# FASCICULE DE BREVET EUROPEEN

(11) **EP 1 091 380 B1**
(45) Date de publication et mention de la délivrance du brevet: **22.03.2006**
(21) Numéro de dépôt: 00402704.1
(22) Date de dépôt: 02.10.2000
(51) Int. Cl.: H01H 85/20, H05K 5/00, H01R 13/514

(54) **Ensemble de modules pour la réalisation de boîtes à fusibles**
Anordnung von Modulen zur Bildung von Sicherungskasten
Assembly of modules for fuse housings

(30) Priorité: 05.10.1999 FR 9912399
(43) Date de publication de la demande: 11.04.2001
(73) Titulaire: Valeo Electronique et Systemes de Liaison, 78180 Montigny le Bretonneux (FR)
(72) Inventeur: Torcheux, Bertrand, 78370 Plaisir (FR)
(74) Mandataire: Faber, Jean-Paul

(56) Documents cités:
- EP-A- 0 116 991
- EP-A- 0 170 455
- EP-A- 0 508 059
- DE-A- 2 361 705
- FR-A- 2 308 219
- FR-A- 2 386 899
- US-A- 4 082 408

## Description

On connaît différents types de modules destinés à la réalisation de boîtes de connexion, boîtes à fusibles, etc... Ces modules sont généralement constitués d'éléments de forme générale parallélépipédique qui présentent, sur deux côtés opposés, des rainures permettant de les assembler entre eux aux moyens d'organes de liaison s'insérant dans lesdites rainures.

Une telle disposition présente notamment l'inconvénient d'augmenter les dimensions de ces boîtes par rapport aux dimensions des boîtes réalisées d'une manière unitaire, de sorte que l'encombrement de telles boîtes à fusibles est incompatible avec celui disponible dans un véhicule automobile notamment.

L'un des buts de la présente invention est notamment de remédier à cet inconvénient. Le document FR2 308219 decrit un ensemble selon le préambule de la revendication 1.

Selon l'invention, l'ensemble de modules pour 1a réalisation de boîtes à fusibles comprend des modules affectant une forme générale parallélépipédique agencés de manière à recevoir des organes électriques de contact, des fusibles, des relais, etc..., lesdits modules comportant des moyens pour leur assemblage à des modules voisins chaque module comportant, sur deux parois latérales adjacentes, des reliefs en queue d'aronde terminés, à une extrémité, par des crochets élastiques, dont les becs sont tournés vers l'extérieur, des épaulements étant ménagés de part et d'autre des crochets, tandis que les deux autres parois comportent des rainures en forme de queue d'aronde correspondant aux reliefs et terminées par des butées destinées à coopérer avec les épaulements d'un module voisin et des rebords destinés à coopérer avec les becs des crochets dudit module voisin.

Grâce à cette disposition, on peut réaliser, en assemblant une série de modules entre eux, des boîtes de connexion présentant un encombrement sensiblement égal à ceux réalisés en une seule pièce. De plus, la boîte ainsi réalisée forme un ensemble parfaitement monobloc, les modules ne risquant pas de se désaccoupler intempestivement.

Suivant une autre caractéristique, l'ensemble de modules comprend un module de base affectant, en plan, une forme générale rectangulaire dont les grands côtés présentent une longueur correspondant à deux fois celles des petits côtés afin de présenter deux éléments de base carrés identiques.

Enfin, suivant une dernière caractéristique, l'ensemble de modules comprend une série de modules de dimensions différentes et formés de multiples d'un élément de base.

L'invention va maintenant être décrite avec plus de détails en se référant à un mode de réalisation particulier donné à titre d'exemple seulement et représenté aux dessins annexés, dans lesquels :

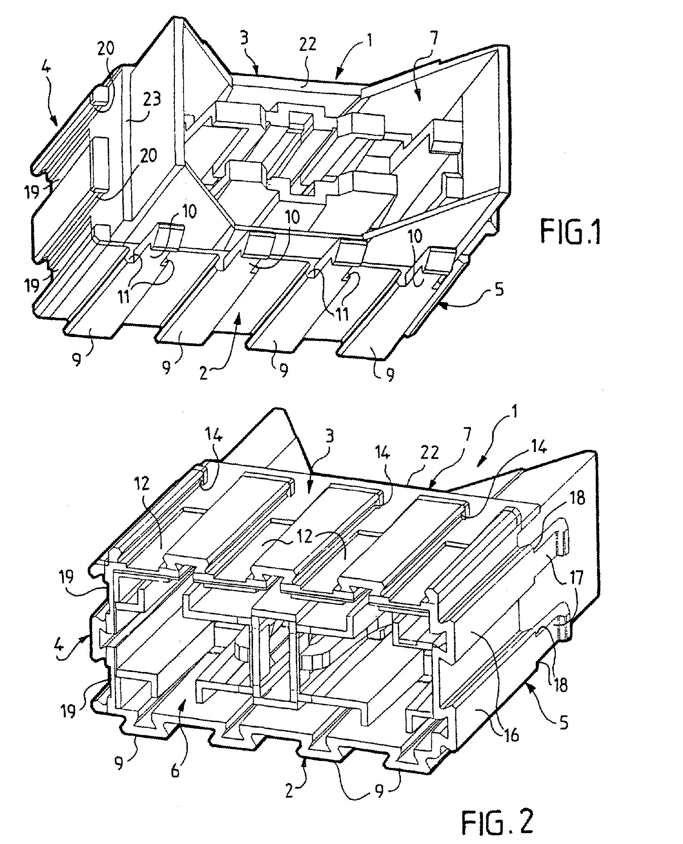

Figure 1 et figure 2 sont des vues en perspective d'un module, selon l'invention.
Figure 3 est une vue en élévation d'un côté du module.
Figure 4 est une vue en coupe suivant la ligne 4-4 de la figure 3.
Figure 5 est une vue en élévation du côté opposé à celui de la figure 3.
Figure 6 est une vue en coupe suivant la ligne 6-6 de la figure 5.
Figure 7 est une vue en coupe suivant la ligne 7-7 de la figure 8.
Figure 8 est une vue en coupe suivant la ligne 8-8 de la figure 7.
Figures 9 à 13 sont des vues en plan montrant les différents modules utilisables pour la réalisation d'une boîte à fusibles.
Figure 14 est une vue en plan montrant un exemple de réalisation d'une boîte à fusibles réalisée avec les différents modules des figures 9 à 13.
Aux figures 1 et 2, on a représenté en perspective un module 1 correspondant à celui représenté à la figure 11. Ce module a une forme générale parallélépipédique avec deux grands côtés latéraux 2 et 3 et deux petits côtés 4 et 5, une extrémité inférieure 6 et une extrémité supérieure 7.

Intérieurement, ce module 1 présente une configuration permettant de loger des contacts avec lesquels coopèreront des plots de fusibles. Egalement, il peut être conformé pour recevoir des contacts destinés à coopérer avec des contacts correspondants de relais.

La paroi latérale 2 présente une série de reliefs 9 à section en queue d'aronde et dont les extrémités sont terminées par des crochets élastiques 10, des épaulements 11 étant ménagés de part et d'autre de chaque crochet 10.

La paroi latérale 3 présente une série de rainures 12 à section en queue d'aronde et correspondant aux reliefs 9, les extrémités des rainures, tournées du côté de l'extrémité 7, comportent des butées 14 destinées à coopérer avec les épaulements 11.

Le petit côté 5 comporte deux reliefs 16 prolongés, chacun, du côté de l'extrémité 7 par un crochet 17, des épaulements 18 étant ménagés de part et d'autre des crochets 17. Les reliefs ont une section en queue d'aronde.

Le petit côté 4 est conformé pour présenter deux rainures 19 en queue d'aronde et correspondant aux reliefs, des épaulements 20 étant prévus aux extrémités desdites rainures 19.

Les différents crochets 10 et 17 présentent un bec tourné vers l'extérieur et sont légèrement éloignés de la paroi latérale correspondante de manière à pouvoir présenter un certain débattement élastique.

Les parois latérales 3 et 4, du côté de l'extrémité 7, présentent des rebords respectivement 22 et 23.

Le module peut s'assembler avec un module correspondant en engageant les reliefs 9 d'une paroi 2 d'un module dans les rainures 12 de la paroi 3 d'un autre module de manière que les épaulements 11 viennent porter contre les butées 14. Dans cette position, les crochets 10 viennent, par leur bec, coopérer avec le rebord 22. Ainsi, une fois assemblés, les modules ne peuvent plus se désaccoupler.

On peut, également, assembler les petits côtés 5 soit à un petit côté correspondant 4, soit sur un grand côté 3 d'un autre module, les reliefs 16 étant engagés dans les rainures 12 ou 19 et le verrouillage étant obtenu de la même façon que précédemment.

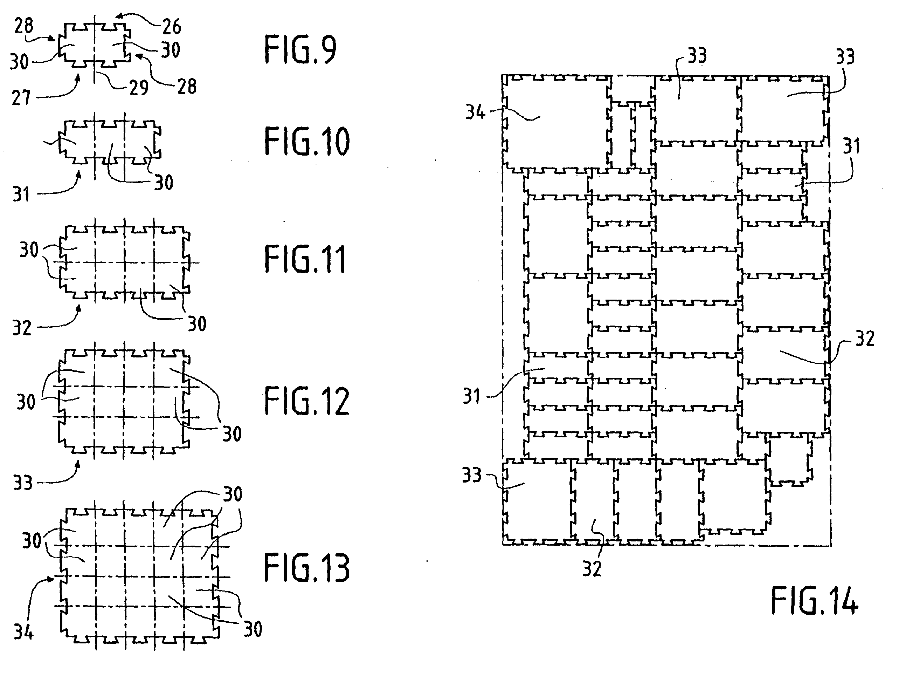

La figure 9 montre un module de base qui affecte, en plan, une forme générale rectangulaire avec deux grands côtés 26 et 27 qui ont une longueur correspondant au double des petits côtés 28.

La référence 29 désigne la ligne médiane passant par les grands côtés et découpant le module de base en deux éléments carrés identiques 30.

Les différents modules représentés aux figures 9 à 13 correspondent tous à des multiples des carrés 30.

Ainsi, le module 31 de la figure 10 correspond à trois fois la dimension de l'élément de base 30.

A la figure 11, on a représenté un module 32 qui est formé de huit éléments de base 30.

La figure 12 montre un module 33 formé de douze éléments de base 30 et enfin la figure 13 représente un module 34 formé de vingt éléments de base 30.

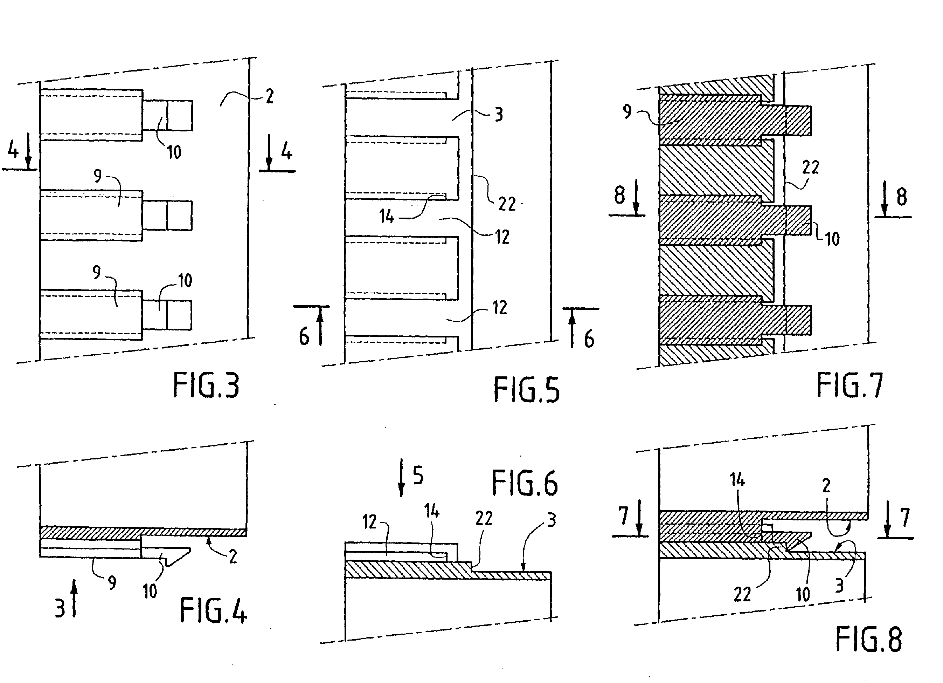

La figure 14 montre un exemple de réalisation d'une boîte à fusibles réalisée avec les différents modules représentés aux figures 5 à 8.

## Revendications

1. Ensemble de modules pour la réalisation notamment de boîtes à fusibles, lesdits modules affectant une forme générale parallélépipédique et étant agencés pour recevoir des organes électriques de contact, des fusibles et des relais, lesdits modules comportant des moyens pour leur assemblage à des modules voisins, chaque module comportant, sur deux parois latérales adjacentes, des reliefs en queue d'aronde (9) terminés, à une extrémité, par des crochets élastiques (10) dont les becs sont tournés vers l'extérieur, des épaulements (11) étant ménagés de part et d'autre des crochets (10), tandis que les deux autres parois comportent des rainures (12) en forme de queue d'aronde correspondant aux reliefs et des rebords (22) destinés à coopérer avec les becs des crochets d'un module voisin, **caractérisé en ce que** les rainures (12) sont terminés par des butées (14) destinées à coopérer avec les épaulements dudit module voisin.

2. Ensemble de modules, selon la revendication 1, **caractérisé en ce qu'**il comprend un module de base affectant, en plan, une forme générale rectangulaire dont les grands côtés présentent une longueur correspondant à deux fois celles des petits côtés afin de présenter deux éléments de base carrésidentiques.(30).

3. Ensemble de modules, selon la revendication 2, **caractérisé en ce qu'**il comprend une série de modules de dimensions différentes et formésde multiples d'un élément de base (30).

## Patentansprüche

1. Anordnung von Modulen, insbesondere zur Bildung von Sicherungskästen, wobei genannte Module eine im großen Ganzen quaderartige Form besitzen und dazu eingerichtet sind, um elektrische Kontaktorgane, Sicherungen und Relais aufzunehmen, wobei genannte Module Mittel für ihren Zusammenbau mit benachbarten Modulen umfassen, jedes Modul auf zwei benachbarten Seitenwänden schwalbenschwanzartige Erhebungen (9) aufweist, die an einem Ende in federnden Haken (10) enden, deren Nasen nach außen gerichtet sind und Absätze (11) zu beiden Seiten der Haken (10) angeordnet sind, während die zwei übrigen Wände Nuten (12) mit schwalbenschwanzartiger, den Erhebungen entsprechender Form, sowie Ränder (22) umfassen, die für die Zusammenwirkung mit den Nasen der Haken eines benachbarten Modules vorgesehen sind, **dadurch gekennzeichnet, dass** die Nuten (12) an Anschlägen (14) enden, die für die Zusammenwirkung mit den Absätzen des genannten, benachbarten Modules vorgesehen sind.

2. Anordnung von Modulen nach Anspruch 1, **dadurch gekennzeichnet, dass** sie ein Grundmodul umfasst, das im Grundriß eine im großen Ganzen rechteckige Form besitzt, deren lange Seiten eine Länge haben, die dem Zweifachen derjenigen der kurzen Seiten entspricht, um zwei gleiche, quadratische Grundelemente (30) zur Verfügung zu stellen.

3. Anordnung von Modulen nach Anspruch 2, **dadurch gekennzeichnet, dass** sie eine Gruppe von Modulen unterschiedlicher Abmessungen umfasst, die aus Vielfachen des Grundelementes (30) gebildet sind.

## Claims

1. Assembly of modules for the production in particular of fuse housings, said modules generally having a parallelepiped shape and being designed for receiving electrical contact elements, fuses and relays, said modules comprising means for connecting with adjacent modules, each module comprising on two lateral adjacent walls dovetail protruding sections (9) terminated at one end by flexible hooks (10), the noses of which are turned towards the exterior, the shoulders (11) being arranged on either side of the hooks (10), whilst the two other walls comprise grooves (12) in the form of a dovetail matching with the protruding sections, and the edges (22) designed to cooperate with the noses of the hooks of an adjacent module, **characterised in that** the grooves (12) are terminated by abutments (14) designed to cooperate with the shoulders of said adjacent module.

2. Assembly of modules according to claim 1, **characterised in that** it comprises a base module forming, in plan view, a general rectangular shape, the long sides of which have a length corresponding to twice that of the short sides in order to provide two identical square base elements (30).

3. Assembly of modules according to claim 2, **characterised in that** it comprises a series of modules with different dimensions and which are formed from multiples of a base element (3).
